# EUROPEAN PATENT SPECIFICATION

(11) **EP 2 804 215 B1**
(45) Date of publication and mention of the grant of the patent: **21.02.2018**
(21) Application number: 12864703.9
(22) Date of filing: 27.11.2012
(51) Int. Cl.: H01L 29/78, H01L 21/336, H01L 29/12, H01L 29/739

(54) **METHOD FOR MANUFACTURING SILICON CARBIDE SEMICONDUCTOR DEVICE**
HERSTELLUNGSVERFAHREN FÜR EIN SILICIUMCARBIDHALBLEITERBAUELEMENT
PROCÉDÉ DE FABRICATION DE DISPOSITIF À SEMI-CONDUCTEURS DE CARBURE DE SILICIUM

(30) Priority: 12.01.2012 JP 2012003895
(43) Date of publication of application: 19.11.2014
(73) Proprietor: Sumitomo Electric Industries, Ltd., Osaka-shi, Osaka 541-0041 (JP); National University Corporation Nara Institute of Science and Technology, Ikoma-shi, Nara 630-0192 (JP)
(72) Inventor: HIYOSHI, Toru, Osaka-shi Osaka 554-0024 (JP); MASUDA, Takeyoshi, Osaka-shi Osaka 554-0024 (JP); HATAYAMA, Tomoaki, Ikoma-shi Nara 630-0192 (JP)
(74) Representative: Grünecker Patent- und Rechtsanwälte PartG mbB
(86) International application number: PCT/JP2012/080592
(87) International publication number: WO 2013/105349

(56) References cited:
- JP-A- 2009 123 753
- JP-A- 2009 190 953
- JP-A- 2011 233 780
- US-A1- 2010 173 475
- HATAYAMA T ET AL: "Thermal Etching of 4H-SiC(0001) Si Faces in the Mixed Gas of Chlorine and Oxygen", 20090601, vol. 48, no. 6, 1 June 2009 (2009-06-01), pages 66516-1, XP001549644,

## Description

### TECHNICAL FIELD

The present invention relates to a method for manufacturing a silicon carbide semiconductor device, more particularly, a method for manufacturing a silicon carbide semiconductor device using heat treatment.

### BACKGROUND ART

Ideally, a silicon carbide single crystal has a crystal structure in which carbon atoms and silicon atoms are arranged in a perfectly orderly manner. Actually, carbon vacancies are inevitably formed in a silicon carbide layer epitaxially grown. The carbon vacancies, which are one type of crystal defect, can decrease performance of a silicon carbide semiconductor device using a silicon carbide layer. Accordingly, a method for reducing density of carbon vacancies is required.

According to Japanese Patent Laying-Open No. 2008-53667 (Patent Literature 1), in order to form a source of an excess of interstitial carbon atoms relative to defects existing in a SiC crystal layer, interstitial carbon atoms are introduced into a surface layer located in an end surface of the SiC crystal layer, by means of ion implantation of atoms such as carbon atoms, silicon atoms, hydrogen atoms, and helium atoms into the surface layer. Then, the interstitial carbon atoms thus introduced into the surface layer are diffused into a material (bulk layer) located below the layer in which they have been introduced, and the interstitial carbon atoms are coupled to atomic vacancies in the bulk layer.

According to Liutauras Storastal et.al, "Reduction of traps and improvement of carrier lifetime in 4H-SiC epilayers by ion implantation", Appl. Phys. Lett., Vol. 90, 062116 (2007) (Non-Patent Literature 1), Z_{1/2} center in 4H-SiC is disclosed. Further, according to Liutauras Storastal et.al, "Enhanced annealing of the Z1/2 defect in 4H-SiC epilayers", J. Appl. Phys., Vol. 103, 013705 (2008) (Non-Patent Literature 2), it is disclosed that Z_{1/2} is associated with carbon vacancies.

### CITATION LIST

### PATENT LITERATURE

PTL 1: Japanese Patent Laying-Open No. 2008-53667

### NON PATENT LITERATURE

NPL 1: Liutauras Storastal et.al, "Reduction of traps and improvement of carrier lifetime in 4H-SiC epilayers by ion implantation", Appl. Phys. Lett., Vol. 90, 062116 (2007)
NPL 2: Liutauras Storastal et.al, "Enhanced annealing of the Z1/2 defect in 4H-SiC epilayers", J. Appl. Phys., Vol. 103, 013705 (2008). The article from Hatayama T et al. "Thermal Etching of 4H-SiC(0001) Si Faces in the Mixed Gas of Chlorine and Oxygen", published in the Japanese Journal of Applied Physics, vol. 48, no. 6, 1 June 2009, pages 66516-1 to 66516-7 discloses thermally etching a silicon carbide layer, a carbon film being formed on said silicon carbide layer by the step of thermally etching.

### SUMMARY OF INVENTION

### TECHNICAL PROBLEM

If the ion implantation method is employed in the method for reducing the carbon vacancies, the silicon carbide layer will be physically damaged.

The present invention has been made to solve the foregoing problem, and has its object to provide a method for manufacturing a silicon carbide semiconductor device having a higher quality silicon carbide layer by reducing density of carbon vacancies in a silicon carbide layer while avoiding damage on the silicon carbide layer.

### SOLUTION TO PROBLEM

A method for manufacturing a silicon carbide semiconductor device in the present invention includes the steps as defined in claim 1. According to this manufacturing method, the carbon atoms diffused from the carbon film into silicon carbide are coupled to the carbon vacancies in the silicon carbide layer. Accordingly, the carbon vacancy density in the silicon carbide layer can be reduced. Accordingly, the silicon carbide semiconductor device having a higher quality silicon carbide layer is obtained.

The silicon carbide semiconductor device may include a bipolar type semiconductor device. In the bipolar type semiconductor device, electrons and positive holes are both used as carriers. With the carbon vacancy density in the silicon carbide layer being reduced as described above, recombination of electrons with positive holes due to the carbon vacancies can be less frequent. Accordingly, performance of the bipolar type semiconductor device can be improved.

Preferably, the heat treatment to the silicon carbide layer is performed at a temperature higher than a temperature at which the silicon carbide layer is heated in the thermal etching. In this way, carbon is diffused more sufficiently. Accordingly, the carbon vacancy density can be reduced more sufficiently.

Preferably, the process gas includes an etching gas containing chlorine atoms. This achieves increased reactivity of the process gas with silicon carbide.

Preferably, the process gas includes an oxidizing gas containing oxygen atoms. Accordingly, the reactivity of the process gas with the carbon film formed on the surface of the silicon carbide layer by the thermal etching on the silicon carbide layer can be increased.

Preferably, concentration of the oxidizing gas in the process gas is decreased during the thermal etching. In this way, the etching rate for the carbon film is made small, thereby more sufficiently forming the carbon film. Accordingly, carbon can be supplied more sufficiently from the carbon film into silicon carbide.

Preferably, after the heat treatment, the carbon film remaining is removed. Accordingly, an unnecessary carbon film is removed.

The thermal etching may be performed to form a trench in the silicon carbide layer. Accordingly, with the thermal etching, the trench can be formed in addition to the carbon film. Further, a gate electrode may be formed in the trench. In this way, a trench gate can be formed.

### ADVANTAGEOUS EFFECTS OF INVENTION

As described above, according to the present invention, there can be obtained a silicon carbide semiconductor device having a higher quality silicon carbide layer.

### BRIEF DESCRIPTION OF DRAWINGS

Fig. 1 is a cross sectional view schematically showing a configuration of a silicon carbide semiconductor device in a first embodiment of the present invention.
Fig. 2 is a cross sectional view schematically showing a first step of a method for manufacturing the silicon carbide semiconductor device of Fig. 1.
Fig. 3 is a cross sectional view schematically showing a second step of the method for manufacturing the silicon carbide semiconductor device of Fig. 1.
Fig. 4 is a cross sectional view schematically showing a third step of the method for manufacturing the silicon carbide semiconductor device of Fig. 1.
Fig. 5 is a cross sectional view schematically showing a fourth step of the method for manufacturing the silicon carbide semiconductor device of Fig. 1.
Fig. 6 is a cross sectional view schematically showing a fifth step of the method for manufacturing the silicon carbide semiconductor device of Fig. 1.
Fig. 7 is a cross sectional view schematically showing a sixth step of the method for manufacturing the silicon carbide semiconductor device of Fig. 1.
Fig. 8 is a cross sectional view schematically showing a seventh step of the method for manufacturing the silicon carbide semiconductor device of Fig. 1.
Fig. 9 is a cross sectional view schematically showing an eighth step of the method for manufacturing the silicon carbide semiconductor device of Fig. 1.
Fig. 10 is a cross sectional view schematically showing a ninth step of the method for manufacturing the silicon carbide semiconductor device of Fig. 1.
Fig. 11 is a cross sectional view schematically showing a tenth step of the method for manufacturing the silicon carbide semiconductor device of Fig. 1.
Fig. 12 is a cross sectional view schematically showing a variation of the silicon carbide semiconductor device of Fig. 1.
Fig. 13 is a partial cross sectional view schematically showing one exemplary side surface of a trench provided in a silicon carbide layer provided in the silicon carbide semiconductor device of Fig. 1.
Fig. 14 is a cross sectional view schematically showing a configuration of a silicon carbide semiconductor device in a second embodiment of the present invention.
Fig. 15 is a cross sectional view schematically showing a first step of a method for manufacturing the silicon carbide semiconductor device of Fig. 14.
Fig. 16 is a cross sectional view schematically showing a second step of the method for manufacturing the silicon carbide semiconductor device of Fig. 14.
Fig. 17 is a cross sectional view schematically showing a third step of the method for manufacturing the silicon carbide semiconductor device of Fig. 14.
Fig. 18 is a cross sectional view schematically showing a fourth step of the method for manufacturing the silicon carbide semiconductor device of Fig. 14.
Fig. 19 is a cross sectional view schematically showing a fifth step of the method for manufacturing the silicon carbide semiconductor device of Fig. 14.
Fig. 20 is a cross sectional view schematically showing a sixth step of the method for manufacturing the silicon carbide semiconductor device of Fig. 14.
Fig. 21 is a cross sectional view schematically showing a seventh step of the method for manufacturing the silicon carbide semiconductor device of Fig. 14.
Fig. 22 is a cross sectional view schematically showing an eighth step of the method for manufacturing the silicon carbide semiconductor device of Fig. 14.
Fig. 23 is a cross sectional view schematically showing a ninth step of the method for manufacturing the silicon carbide semiconductor device of Fig. 14.
Fig. 24 is a partial cross sectional view schematically showing one exemplary surface of a silicon carbide layer provided in the silicon carbide semiconductor device of Fig. 14.

### DESCRIPTION OF EMBODIMENTS

The following describes embodiments of the present invention with reference to figures. It should be noted that in the below-mentioned figures, the same or corresponding portions are given the same reference characters and are not described repeatedly. Regarding crystallographic indications of the present specification, an individual plane is represented by (), and a group plane is represented by {}. In addition, a negative index is supposed to be crystallographically indicated by putting "- " (bar) above a numeral, but is indicated by putting the negative sign before the numeral in the present specification.

### (First Embodiment)

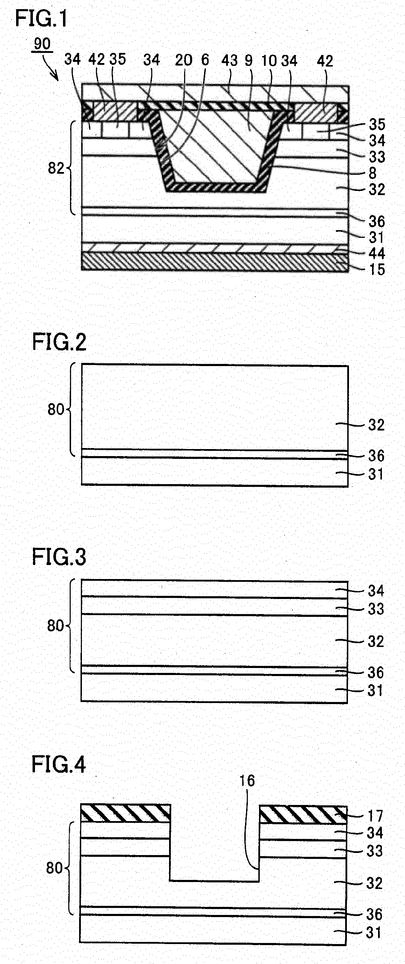

As shown in Fig. 1, a silicon carbide semiconductor device of the present embodiment is a trench gate type IGBT 90 (Insulated Gate Bipolar Transistor), which is one type of a bipolar type semiconductor device. IGBT 90 includes: a substrate 31 having p type conductivity; and a silicon carbide layer 82 epitaxially formed on a main surface (upper surface in the figure) of substrate 31. Substrate 31 is made of silicon carbide having a hexagonal crystal form or silicon carbide having a cubic crystal form. Correspondingly, silicon carbide layer 82 epitaxially formed on substrate 31 is also made of silicon carbide having a hexagonal crystal form or silicon carbide having a cubic crystal form. Further, IGBT 90 further includes gate insulating films 8, a gate electrode 9, an interlayer insulating film 10, emitter electrodes 42, an emitter wiring layer 43, a collector electrode 44, and a protecting electrode 15.

Silicon carbide layer 82 includes: a buffer layer 36 having p type conductivity; a drift layer 32 having n type conductivity; body regions 33 having p type conductivity; emitter regions 34 having n type conductivity; and contact regions 35 having p type conductivity. Buffer layer 36 is provided on one main surface of substrate 31. Drift layer 32 is provided on buffer layer 36. Each of body regions 33 is provided on drift layer 32. Each of emitter regions 34 is provided on body region 33. Each of contact regions 35 is surrounded by emitter regions 34.

Silicon carbide layer 82 has a carbon vacancy density lower than that of a normal epitaxial layer of silicon carbide. Correspondingly, silicon carbide layer 82 has a low Z_{1/2} center density. Specifically, the Z_{1/2} center density of silicon carbide layer 82 is 1 × 10¹² cm⁻³ or smaller.

Silicon carbide layer 82 has a trench 6. Trench 6 extends through emitter region 34 and body region 33 to reach drift layer 32. Trench 6 has side walls 20 inclined relative to the main surface of substrate 31. In other words, each of side walls 20 is inclined relative to the main surface (upper surface in the figure) of silicon carbide layer 82. The side wall thus inclined surrounds a projection portion (projection-shaped portion having an upper surface on which emitter electrode 42 is formed). The projection portion may have, for example, a hexagonal planar shape in the case where substrate 31 has a hexagonal crystal form. Meanwhile, in the case where substrate 31 has a cubic crystal form, the projection portion may have a quadrangular planar shape, for example. In the case where silicon carbide layer 82 has a hexagonal crystal form, side wall 20 of trench 6 includes at least one of a {0-33-8} plane and a {01-1-4} plane. Further, in the case where silicon carbide layer 82 has a cubic crystal form, side wall 20 includes a {100} plane.

Gate insulating film 8 is provided on side walls 20 and bottom surface of trench 6. Gate insulating film 8 extends onto the upper surface of each of emitter regions 34. Gate electrode 9 is provided to fill the inside of trench 6 with gate insulating film 8 interposed therebetween. Interlayer insulating film 10 covers gate electrode 9 as well as portions of gate insulating film 8 on the upper surfaces of emitter regions 34. In the portions at which interlayer insulating film 10 and gate insulating film 8 are provided on each other, openings are provided to expose portions of emitter regions 34 and contact regions 35 of p type. Emitter electrodes 42 are provided to fill the insides of the openings so as to make contact with contact regions 35 of p type and emitter regions 34. Emitter wiring layer 43 is in contact with the upper surface of emitter electrode 42, and extends on interlayer insulating film 10.

Collector electrode 44 is provided on a main surface opposite to the main surface on which buffer layer 36 is provided. Protecting electrode 15 covers collector electrode 44.

The following describes gist of usage of IGBT 90. A voltage is applied between emitter wiring layer 43 and protecting electrode 15 such that protecting electrode 15 has a positive potential relative to emitter wiring layer 43. Electric conduction between emitter wiring layer 43 and protecting electrode 15 is switched in accordance with a potential applied to gate electrode 9. Specifically, when gate electrode 9 is fed with a negative potential exceeding a threshold value, an inversion layer is formed in each body region 33 at a region (channel region) facing gate electrode 9 with gate insulating film 8 interposed therebetween. Accordingly, emitter region 34 and drift layer 32 are electrically connected to each other. Accordingly, electrons are injected from each of emitter regions 34 to drift layer 32. Correspondingly, positive holes are supplied from substrate 31 to drift layer 32 through buffer layer 36. As a result, conductivity modulation takes place in drift layer 32, thus significantly decreasing a resistance between emitter electrode 42 and collector electrode 44. In other words, IGBT 90 is brought into ON state. Meanwhile, when gate electrode 9 is not fed with the above-described potential, no inversion layer is formed in the channel region, thereby maintaining a reverse-bias state between drift layer 32 and body region 33. Thus, IGBT 90 is in OFF state.

The following describes a method for manufacturing IGBT 90.

As shown in Fig. 2, a silicon carbide layer 80 is formed on substrate 31. Specifically, buffer layer 36 of p type is epitaxially formed on substrate 31 of p type. On buffer layer 36, drift layer 32 of n type is epitaxially formed. As a method for forming silicon carbide layer 80, for example, a chemical vapor deposition (CVD) method can be used. As a source material gas in the CVD method, a mixed gas of silane (SiH₄) and propane (C₃H₈) can be used. As a carrier gas for the source material gas, hydrogen gas (H₂) can be used, for example. As an impurity for providing p type conductivity, aluminum (Al) can be used, for example. As an impurity for providing n type conductivity, nitrogen (N) or phosphorus (P) can be used, for example.

As shown in Fig. 3, by means of ion implantation into drift layer 32, body region 33 of p type and emitter region 34 of n type are formed. In the ion implantation for forming body region 33, aluminum (Al) or the like can be implanted, for example. In the ion implantation for forming emitter region 34, phosphorus (P) or the like can be implanted, for example.

Referring to Fig. 4, a mask layer 17 having an opening is formed on emitter region 34. Mask layer 17 is made of silicon oxide, for example. Next, through etching using mask layer 17, a vertical trench 16 is formed in silicon carbide layer 80. As an etching method, ion milling or reactive ion etching (RIE) can be used, for example. As the RIE, inductively coupled plasma (ICP) RIE can be used in particular. As a reactive gas in the RIE, SF₆ or a mixed gas of SF₆ and O₂ can be used, for example.

Next, thermal etching is performed onto silicon carbide layer 80 (Fig. 4) so as to expand vertical trench 16 (Fig. 4). The thermal etching is performed by supplying silicon carbide layer 80 with a process gas that can chemically react with silicon carbide, while heating silicon carbide layer 80.

The process gas preferably includes at least one of an etching gas containing chlorine atoms, CF₄ gas, CHF₃ gas, and SF₆ gas. More preferably, the process gas includes an etching gas containing chlorine atoms. An exemplary, usable etching gas is Cl₂ gas. Preferably, the process gas includes an oxidizing gas containing oxygen atoms. As the oxidizing gas, O₂ gas, CO gas, NO gas, or N₂O gas can be used, for example. Preferably, O₂ gas is used. In the case where a mixed gas of O₂ gas and Cl₂ gas is used as the process gas, it is preferable that when supplying the mixed gas, a ratio of a flow rate of O₂ to a flow rate of Cl₂ is at least temporarily not less than 0.1 and not more than 2.0. More preferably, the ratio is not less than 0.25.

It should be noted that the process gas may contain a carrier gas. An exemplary, usable carrier gas is N₂ gas, Ar gas, or He gas.

Further, the heat treatment in the thermal etching is performed at a temperature of not less than 700°C and not more than 1200°C. When the heat treatment temperature is set at not less than 700°C, a rate of etching SiC can be secured to be approximately 70 µm/hr. The lower limit of the temperature is more preferably 800°C or greater, further preferably 900°C or greater. The upper limit of the temperature is more preferably 1100°C or smaller, further preferably 1000°C or smaller. Further, when mask layer 17 is made of a material such as silicon oxide, silicon nitride, aluminum oxide, aluminum nitride, or gallium nitride in this case, etching selectivity of SiC to the material of mask layer 17 can be made very large, thereby suppressing consumption of mask layer 17 during the etching of SiC.

On the thermally etched surface of silicon carbide layer 80, a carbon film is formed. This is because carbon atoms are less likely to be removed from the thermally etched surface thereof as compared with silicon atoms. A part of carbon atoms in the carbon film are diffused into silicon carbide layer 80 due to a diffusion phenomenon resulting from the heat treatment in the thermal etching. A part of the carbon atoms thus diffused into silicon carbide layer 80 are coupled to carbon vacancies in silicon carbide layer 80, thus resulting in extinction of a part of the carbon vacancies. In this way, the carbon vacancy density is reduced.

In the case where the concentration of the oxidizing gas in the process gas is low or zero, an etching rate for the carbon film will be low. Accordingly, a thick carbon film is more likely to be formed. In contrast, in the case where the concentration of the oxidizing gas is high, a thick carbon film is less likely to be formed. Accordingly, an etching rate for the silicon carbide can be suppressed from being decreased due to the covering of the carbon film. In the case where the concentration of the oxidizing gas is set to be decreased during the thermal etching, a high etching rate for silicon carbide can be attained before the point of time at which the concentration is set to be decreased, and the carbon film is more likely to be formed after the point of time. In the case where the concentration of the oxidizing gas is thereafter set to be increased again, the carbon film sufficiently formed is etched at a high rate. On this occasion, carbon atoms are actively diffused into silicon carbide layer 80.

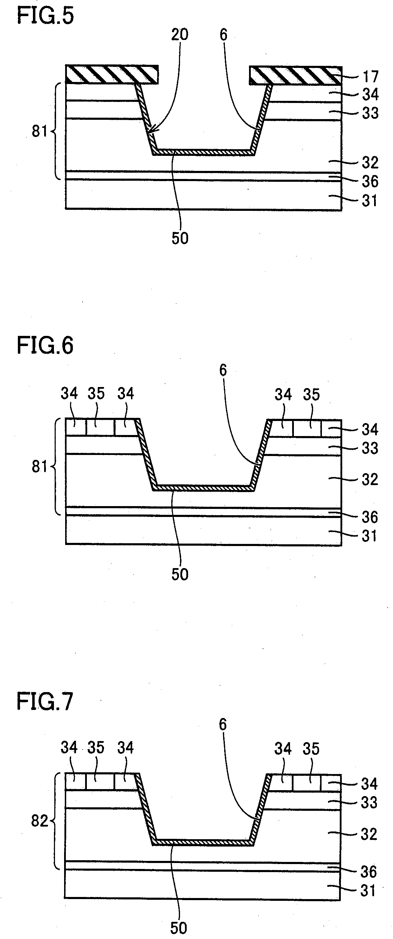

Referring to Fig. 5, with the above-described thermal etching, trench 6 having side walls 20 is formed. In the case where silicon carbide layer 80 has a hexagonal crystal form, each of side walls 20 of trench 6 includes at least one of the {0-33-8} plane and the {01-1-4} plane. On the other hand, in the case where silicon carbide layer 80 has a cubic crystal form, side wall 20 includes the {100} plane. In the case where silicon carbide layer 80 has a hexagonal crystal form, the plane orientation of side wall 20 is, for example, the {0-33-8} plane. Namely, in the etching under the above-described conditions, side wall 20 of trench 6 is spontaneously formed to correspond to the {0-33-8} plane, which is a crystal plane allowing for the slowest etching rate. It should be noted that the plane orientation of side wall 20 may be the {01-1-4} plane. Meanwhile, in the case where silicon carbide layer 80 has a cubic crystal form, the plane orientation of side wall 20 may be the {100} plane. Preferably, as the {0-33-8} plane, a (0-33-8) plane is used. As the {0-11-4} plane, a (0-11-4) plane is used.

Further, with the above-described extinction of part of carbon vacancies, silicon carbide layer 80 (Fig. 4) is changed into silicon carbide layer 81 having a lower carbon vacancy density than that of silicon carbide layer 80. Further, as a result of the above-described thermal etching, carbon film 50 is formed on the inner surface of trench 6.

In the case where a damaged layer exists in the side wall of vertical trench 16, the damaged layer can be removed by the above-described thermal etching. In order to remove the damaged layer more securely, the side wall of vertical trench 16 is preferably thermally etched to a depth of 0.1 µm or greater.

Next, mask layer 17 is removed. For this purpose, wet etching is performed, for example.

As shown in Fig. 6, by means of the ion implantation method, contact regions 35 are formed.

Next, silicon carbide layer 81 is subjected to heat treatment. With this heat treatment, carbon atoms are diffused from carbon film 50 into silicon carbide layer 81. A part of the carbon atoms thus diffused are coupled to carbon vacancies in silicon carbide layer 81 to result in extinction of a part of the carbon vacancies. In this way, the carbon vacancy density is reduced.

Preferably, the heat treatment for silicon carbide layer 81 is performed at a temperature higher than the temperature at which the silicon carbide layer is heated in the thermal etching. The heat treatment for silicon carbide layer 81 is preferably performed at a temperature of 1300°C or greater, more preferably, 1500°C or greater. Further, the temperature of the heat treatment is preferably 1800°C or smaller. For example, the heat treatment is performed at a temperature of approximately 1700°C. When the temperature of the heat treatment is sufficiently high, the impurities in silicon carbide layer 81 are more activated by this heat treatment. The heat treatment is performed for approximately 30 minutes, for example. The atmosphere of the heat treatment is preferably an inert gas atmosphere, such as Ar atmosphere.

Further, as shown in Fig. 7, with the above-described extinction of carbon vacancies, silicon carbide layer 81 (Fig. 6) is changed into silicon carbide layer 82 having a carbon vacancy density lower than that of silicon carbide layer 81.

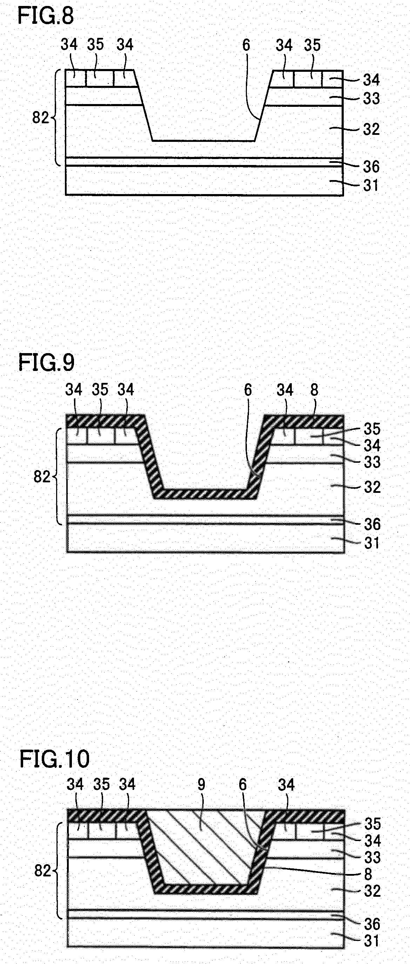

Further, as shown in Fig. 8, carbon film 50 (Fig. 7) remaining after the above-described heat treatment is removed. For this purpose, etching is performed, for example.

As shown in Fig. 9, gate insulating film 8 is formed to extend from the inside of trench 6 onto the upper surfaces of emitter regions 34 and p type contact regions 35. For this purpose, silicon carbide layer 82 is thermally oxidized, for example.

As shown in Fig. 10, gate electrode 9 is formed in trench 6. Gate electrode 9 can be formed by, for example, performing etch-back or CMP (Chemical Mechanical Polishing) after formation of the conductor film.

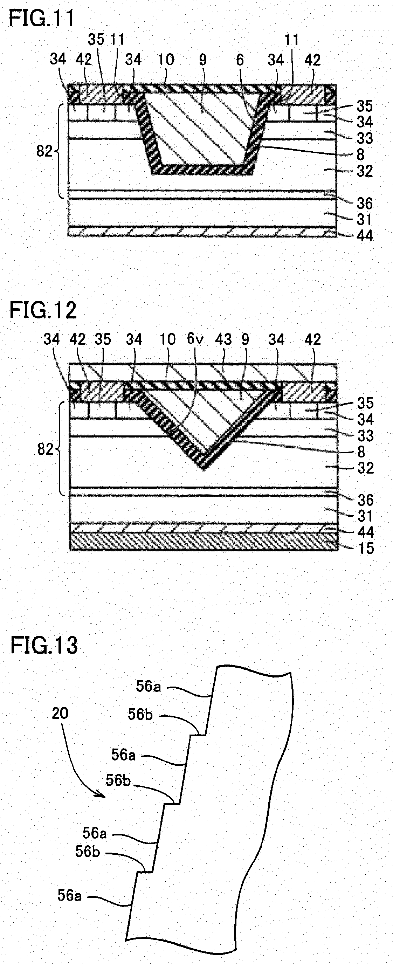

Referring to Fig. 11, interlayer insulating film 10 is formed to cover the upper surface of gate electrode 9 and the upper surface of gate insulating film 8 exposed on contact region 35. Next, openings are formed to expose contact regions 35 and portions of emitter regions 34. Next, in each of the openings, emitter electrode 42 is formed to be an ohmic electrode making contact with each of emitter regions 34 and contact regions 35.

Further, collector electrode 44 serving as an ohmic electrode is formed on the backside surface of substrate 31 (the surface opposite to the side at which buffer layer 36 and drift layer 32 are formed).

Referring to Fig. 1 again, emitter wiring layer 43 is formed to make contact with the upper surface of emitter electrode 42 and extend on the upper surface of interlayer insulating film 10, and protecting electrode 15 is formed to cover collector electrode 44. In this way, IGBT 90 is obtained.

The following describes function and effect of the present embodiment. According to the method for manufacturing IGBT 90 in the present embodiment, carbon film 50 (Fig. 5) is formed on the thermally etched surface of silicon carbide layer 80 (Fig. 4) during the thermal etching. Further, by the heat treatment in the thermal etching, carbon atoms are diffused from carbon film 50 to silicon carbide layer 80 (Fig. 4) and coupled to carbon vacancies in silicon carbide layer 80 (Fig. 4). Accordingly, silicon carbide layer 80 is changed into silicon carbide layer 81 (Fig. 5) having a lower carbon vacancy density. Accordingly, IGBT 90 (Fig. 1) having a higher quality silicon carbide layer is obtained. With this thermal etching, trench 6 allowing gate electrode 9 to be disposed therein can be formed simultaneously.

Preferably, the process gas includes an etching gas containing chlorine atoms. This achieves increased reactivity of the process gas with silicon carbide.

Preferably, the process gas includes an oxidizing gas containing oxygen atoms. Accordingly, the reactivity of the process gas with carbon film 50 formed on the surface of silicon carbide layer 80 by the thermal etching on silicon carbide layer 80 can be increased.

Preferably, the concentration of the oxidizing gas in the process gas is decreased during the thermal etching. In this way, the etching rate for carbon film 50 is made small, thereby more sufficiently forming carbon film 50. Accordingly, carbon can be supplied more sufficiently from carbon film 50 into silicon carbide. More preferably, after the concentration of the oxidizing gas is decreased, the concentration of the oxidizing gas is increased. Accordingly, carbon film 50 formed to be sufficiently thick is etched at a high rate. On this occasion, carbon atoms are actively diffused into silicon carbide layer 80. Accordingly, the carbon vacancy density in silicon carbide layer 80 can be reduced further.

Further, according to the present embodiment, with the heat treatment performed after the thermal etching, carbon atoms are diffused from carbon film 50 into silicon carbide layer 81 (Fig. 6) and are coupled to carbon vacancies in silicon carbide layer 81. Accordingly, silicon carbide layer 81 is changed into silicon carbide layer 82 (Fig. 7) having a lower carbon vacancy density. Accordingly, IGBT 90 (Fig. 1) having a higher quality silicon carbide layer is obtained.

Further, the heat treatment after the thermal etching is performed at a temperature higher than the temperature at which the silicon carbide layer is heated in the thermal etching. Accordingly, the carbon atoms are diffused more actively than those during the thermal etching, whereby the carbon vacancy density can be reduced more sufficiently. Further, with the heat treatment after the thermal etching, impurities can be activated. Moreover, because carbon film 50 serves as a cap film during the heat treatment for this activation, side wall 20 of trench 6 can be suppressed from being rough due to the heat treatment.

Further, IGBT 90, which is the silicon carbide semiconductor device of the present embodiment, is a bipolar type semiconductor device. In the bipolar type semiconductor device, electrons and positive holes are both used as carriers. With the carbon vacancy density in the silicon carbide layer being reduced as described above, recombination of electrons with positive holes due to existence of carbon vacancies can be less frequent. Accordingly, performance of the bipolar type semiconductor device can be improved. Specifically, by improving the density of electrons and positive holes in IGBT 90, on-resistance can be reduced.

Further, according to the present embodiment, carbon film 50 is removed after the heat treatment. Accordingly, an unnecessary carbon film can be removed. Carbon film 50 can be readily removed using, for example, oxidation reaction.

It should be noted that instead of trench 6 (Fig. 1) having a flat bottom surface, a V-shaped trench 6v (Fig. 12) may be used. In this case, the size of the trench when viewed in a plan view can be made smaller. Hence, the size of the IGBT can be made smaller.

In the present specification, the expression "side wall 20 of trench 6 includes a {0-33-8} plane" is intended to indicate a concept including both a case where side wall 20 substantially corresponds to the {0-33-8} plane and a case where there are a plurality of crystal planes constituting side wall 20 and one of the crystal planes is the {0-33-8} plane. Now, the latter case is illustrated as follows. That is, side wall 20 corresponds to a chemically stable plane constituted by, for example, alternately providing a plane 56a and a plane 56b as shown in Fig. 13, microscopically. Plane 56a has a plane orientation of {0-33-8} whereas plane 56b, which is connected to plane 56a, has a plane orientation different from that of plane 56a. Here, the term "microscopically" means "minutely to such an extent that at least the size about twice as large as an interatomic spacing is considered". Preferably, plane 56b has a plane orientation of {0-11-1}. More preferably, plane 56a having a plane orientation of {0-33-8} and plane 56b having a plane orientation of {0-11-1} are combined to constitute a {0-11-2} plane, macroscopically. Here, the term "macroscopically" means "a size sufficiently large is considered to such an extent that interatomic spacing can be ignored". More preferably, in side wall 20 shown in Fig. 13, the length of plane 56a is twice as large as the interatomic spacing on plane 56a, and the length of plane 56b is twice as large as the interatomic spacing on plane 56b.

In the present specification, the expression "side wall 20 of trench 6 includes a {0-11-4} plane" is intended to indicate a concept including both a case where side wall 20 substantially corresponds to the {0-11-4} plane and a case where there are a plurality of crystal planes constituting side wall 20 and one of the crystal planes is the {0-11-4} plane. Further, in the case where side wall 20 includes the {0-33-8} plane, side wall 20 more preferably includes the (0-33-8) plane. Further, in the case where side wall 20 includes the {0-11-4} plane, side wall 20 more preferably includes the (0-11-4) plane. Further, in the case where side wall 20 includes the {0-11-1} plane, side wall 20 more preferably includes the (0-11-1) plane.

In the present specification, the expression "side wall 20 of trench 6 includes a {100} plane" is intended to indicate a concept including both a case where side wall 20 substantially corresponds to the {100} plane and a case where there are a plurality of crystal planes constituting side wall 20 and one of the crystal planes is the {100} plane.

Further, the formation of vertical trench 16 (Fig. 4) in the present embodiment may be omitted. In this case, trench 6 can be formed only by means of the thermal etching.

### (Second Embodiment)

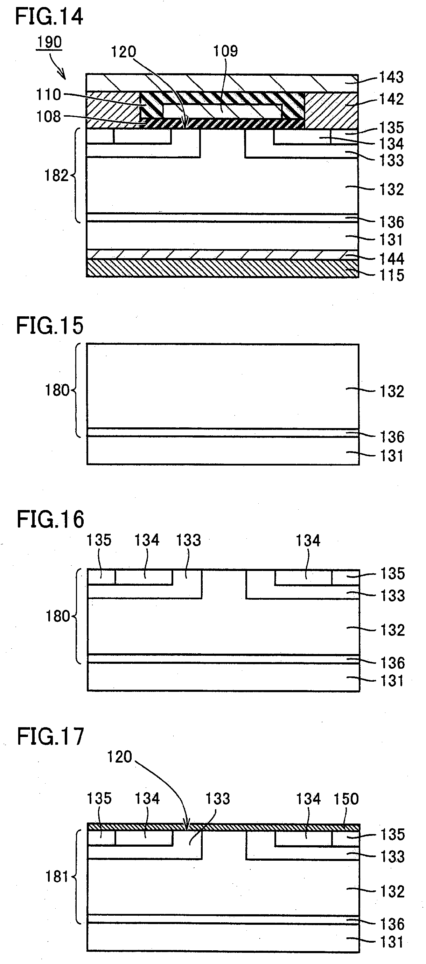

As shown in Fig. 14, a silicon carbide semiconductor device of the present embodiment is a planar type IGBT 190, which is one type of a bipolar type semiconductor device. IGBT 190 includes: a substrate 131 having p type conductivity; and a silicon carbide layer 182 epitaxially formed on a main surface (upper surface in the figure) of substrate 131. Substrate 131 is made of silicon carbide having a hexagonal crystal form or silicon carbide having a cubic crystal form. Correspondingly, silicon carbide layer 182 epitaxially formed on substrate 131 is also made of silicon carbide having a hexagonal crystal form or silicon carbide having a cubic crystal form. Further, IGBT 190 further includes a gate insulating film 108, a gate electrode 109, an interlayer insulating film 110, emitter electrodes 142, an emitter wiring layer 143, a collector electrode 144, and a protecting electrode 115.

Silicon carbide layer 182 includes: a buffer layer 136 having p type conductivity; a drift layer 132 having n type conductivity; body regions 133 having p type conductivity; emitter regions 134 having n type conductivity; and contact regions 135 having p type conductivity. Buffer layer 136 is provided on one main surface of substrate 131. Drift layer 132 is provided on buffer layer 136. Each of body regions 133 is provided on drift layer 132. Each of emitter regions 134 is provided on body region 133. Each of contact regions 135 is surrounded by emitter regions 134.

Silicon carbide layer 182 has a carbon vacancy density lower than that of a normal epitaxial layer of silicon carbide. Correspondingly, silicon carbide layer 182 has a low Z_{1/2} center density. Specifically, the Z_{1/2} center density of silicon carbide layer 182 is 1 x 10¹² cm⁻³ or smaller.

Silicon carbide layer 182 has a surface 120 facing gate insulating film 108. In the case where silicon carbide layer 182 has a hexagonal crystal form, surface 120 includes at least one of a {0-33-8} plane and a {01-1-4} plane. Further, in the case where silicon carbide layer 182 has a cubic crystal form, surface 120 includes a {100} plane.

Gate insulating film 108 is provided on a portion of silicon carbide layer 182, and includes a portion provided on body region 133 so as to connect between emitter region 134 and drift layer 132. Gate electrode 109 is provided on gate insulating film 108. Interlayer insulating film 110 covers gate electrode 109 to provide insulation between gate electrode 109 and emitter wiring layer 143. In the portions at which interlayer insulating film 110 and gate insulating film 108 are provided on each other, openings are provided to expose portions of emitter regions 134 and contact regions 135 of p type. Emitter electrodes 142 are provided to fill the insides of the openings so as to make contact with contact regions 135 of p type and emitter regions 134. Emitter wiring layer 143 is in contact with the upper surface of emitter electrode 142, and extends on interlayer insulating film 110.

Collector electrode 144 is provided on a main surface opposite to the main surface on which buffer layer 136 is provided. Protecting electrode 115 covers collector electrode 144.

The following describes gist of usage of IGBT 190. A voltage is applied between emitter wiring layer 143 and protecting electrode 115 such that protecting electrode 115 has a positive potential relative to emitter wiring layer 143. Electric conduction between emitter wiring layer 143 and protecting electrode 115 is switched in accordance with a potential applied to gate electrode 109. Specifically, when gate electrode 109 is fed with a negative potential exceeding a threshold value, an inversion layer is formed in each body region 133 at a region (channel region) facing gate electrode 109 with gate insulating film 108 interposed therebetween. Accordingly, emitter region 134 and drift layer 132 are electrically connected to each other. Accordingly, electrons are injected from each of emitter regions 134 to drift layer 132. Correspondingly, positive holes are supplied from substrate 131 to drift layer 132 through buffer layer 136. As a result, conductivity modulation takes place in drift layer 132, thus significantly decreasing a resistance between emitter electrode 142 and collector electrode 144. In other words, IGBT 190 is brought into ON state. Meanwhile, when gate electrode 109 is not fed with the above-described potential, no inversion layer is formed in the channel region, thereby maintaining a reverse-bias state between drift layer 132 and body region 133. Thus, IGBT 190 is in OFF state.

The following describes a method for manufacturing IGBT 190.

As shown in Fig. 15, a silicon carbide layer 180 is formed on substrate 131. Specifically, buffer layer 136 of p type is epitaxially formed on substrate 131 of p type. On buffer layer 136, drift layer 132 of n type is epitaxially formed. As a method for forming silicon carbide layer 180, for example, a chemical vapor deposition (CVD) method can be used. As a source material gas in the CVD method, a mixed gas of silane (SiH₄) and propane (C₃H₈) can be used. As a carrier gas for the source material gas, hydrogen gas (H₂) can be used, for example. As an impurity for providing p type conductivity, aluminum (Al) can be used, for example. As an impurity for providing n type conductivity, nitrogen (N) or phosphorus (P) can be used, for example.

As shown in Fig. 16, by means of ion implantation into drift layer 132, body region 133 of p type, emitter region 134 of n type, and contact regions 135 of p type are formed. Contact region 135 has an impurity concentration higher than that of body region 133. In the ion implantation for forming body region 133 and contact regions 135, aluminum (Al) or the like can be implanted, for example. In the ion implantation for forming emitter region 134, phosphorus (P) or the like can be implanted, for example.

Next, the surface (upper surface in Fig. 16) of silicon carbide layer 180 is thermally etched. The thermal etching is performed by supplying silicon carbide layer 180 with a process gas that can chemically react with silicon carbide, while heating silicon carbide layer 180.

Preferably, the process gas includes an etching gas containing chlorine atoms. An exemplary, usable etching gas is chlorine gas. Preferably, the process gas includes an oxidizing gas containing oxygen atoms. An exemplary, usable oxidizing gas is oxygen gas. In the case where a mixed gas of oxygen gas and chlorine gas is used as the process gas, it is preferable that when supplying the mixed gas, a ratio of a flow rate of oxygen to a flow rate of chlorine is preferably not less than 0.1 and not more than 2.0. More preferably, the ratio is not less than 0.25.

It should be noted that the process gas may contain a carrier gas. An exemplary, usable carrier gas is nitrogen (N₂) gas, argon (Ar) gas, helium (He) gas, or the like.

Further, the heat treatment in the thermal etching is performed at a temperature of not less than 700°C and not more than 1200°C. When the heat treatment temperature is set at not less than 700°C, a rate of etching SiC can be secured to be approximately 70 µm/hr. The lower limit of the temperature is more preferably 800°C or greater, further preferably 900°C or greater. The upper limit of the temperature is more preferably 1100°C or smaller, further preferably 1000°C or smaller.

On the thermally etched surface of silicon carbide layer 180, a carbon film is formed. This is because carbon atoms are less likely to be removed from the thermally etched surface thereof as compared with silicon atoms. A part of carbon atoms in the carbon film are diffused into silicon carbide layer 180 due to a diffusion phenomenon resulting from the heat treatment in the thermal etching. A part of the carbon atoms thus diffused into silicon carbide layer 180 are coupled to carbon vacancies in silicon carbide layer 180, thus resulting in extinction of a part of the carbon vacancies. In this way, the carbon vacancy density is reduced.

In the case where the concentration of the oxidizing gas in the process gas is low or zero, an etching rate for the carbon film will be low. Accordingly, a thick carbon film is more likely to be formed. In contrast, in the case where the concentration of the oxidizing gas is high, a thick carbon film is less likely to be formed. Accordingly, an etching rate for the silicon carbide can be suppressed from being decreased due to the covering of the carbon film. In the case where the concentration of the oxidizing gas is set to be decreased during the thermal etching, a high etching rate for silicon carbide can be attained before the point of time at which the concentration is set to be decreased, and the carbon film is more likely to be formed after the point of time. In the case where the concentration of the oxidizing gas is thereafter set to be increased again, the carbon film sufficiently formed is etched at a high rate. On this occasion, carbon atoms are actively diffused into silicon carbide layer 180.

Referring to Fig. 17, with the above-described thermal etching, silicon carbide layer 181 having surface 120 is formed. In the case where silicon carbide layer 180 has a hexagonal crystal form, surface 120 includes at least one of the {0-33-8} plane and the {01-1-4} plane. On the other hand, in the case where silicon carbide layer 180 has a cubic crystal form, surface 120 includes the {100} plane. In the case where silicon carbide layer 180 has a hexagonal crystal form, the plane orientation of surface 120 is, for example, the {0-33-8} plane. Namely, in the etching under the above-described conditions, surface 120 can be spontaneously formed to correspond to the {0-33-8} plane, which is a crystal plane allowing for the slowest etching rate. It should be noted that the plane orientation of surface 120 may be the {01-1-4} plane. Meanwhile, in the case where silicon carbide layer 180 has a cubic crystal form, the plane orientation of surface 120 may be the {100} plane. Preferably, as the {0-33-8} plane, a (0-33-8) plane is used. As the {0-11-4} plane, a (0-11-4) plane is used.

Further, with the above-described extinction of part of carbon vacancies, silicon carbide layer 180 (Fig. 16) is changed into silicon carbide layer 181 having a lower carbon vacancy density than that of silicon carbide layer 180. Further, as a result of the above-described thermal etching, carbon film 150 is formed on surface 120.

In the case where a damaged layer exists in the surface of silicon carbide layer 180 due to machining or the like, the damaged layer can be removed by the above-described thermal etching. In order to remove the damaged layer more securely, the thermal etching is preferably performed to a depth of 0.1 µm or greater.

Next, silicon carbide layer 181 is subjected to heat treatment. With this heat treatment, carbon atoms are diffused from carbon film 150 into silicon carbide layer 181. A part of the carbon atoms thus diffused are coupled to carbon vacancies in silicon carbide layer 181 to result in extinction of a part of the carbon vacancies. In this way, the carbon vacancy density is reduced.

Preferably, the heat treatment for silicon carbide layer 181 is performed at a temperature higher than the temperature at which the silicon carbide layer is heated in the thermal etching. Preferably, the heat treatment temperature is not less than 1500°C, for example, approximately 1700°C. When the heat treatment temperature is sufficiently high, the impurities in silicon carbide layer 181 are activated by this heat treatment. The heat treatment is performed for approximately 30 minutes, for example. The atmosphere of the heat treatment is preferably an inert gas atmosphere, such as Ar atmosphere.

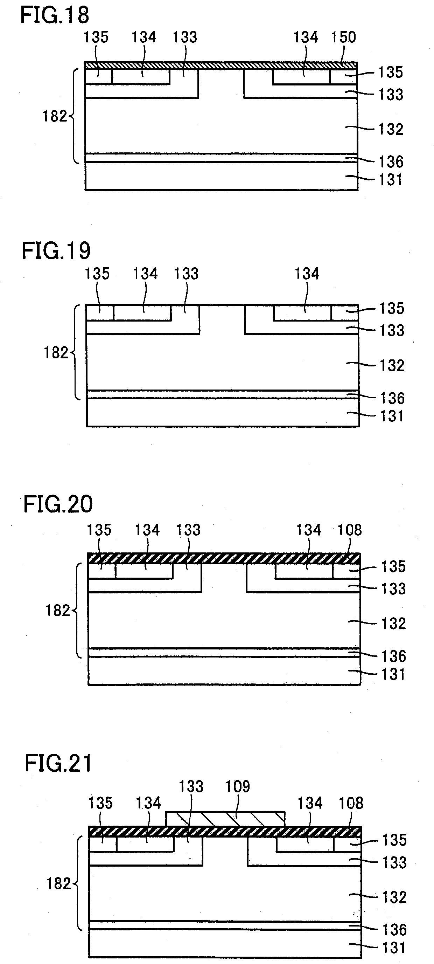

As shown in Fig. 18, with the above-described extinction of carbon vacancies, silicon carbide layer 181 (Fig. 17) is changed into silicon carbide layer 182 having a carbon vacancy density lower than that of silicon carbide layer 181.

Further, as shown in Fig. 19, carbon film 150 (Fig. 18) remaining after the above-described heat treatment is removed. For this purpose, etching is performed, for example.

As shown in Fig. 20, gate insulating film 108 is formed on silicon carbide layer 182. For this purpose, silicon carbide layer 182 is thermally oxidized, for example.

As shown in Fig. 21, gate electrode 109 is formed on gate insulating film 108. Gate electrode 109 can be formed by, for example, forming a conductor film and patterning the conducting film.

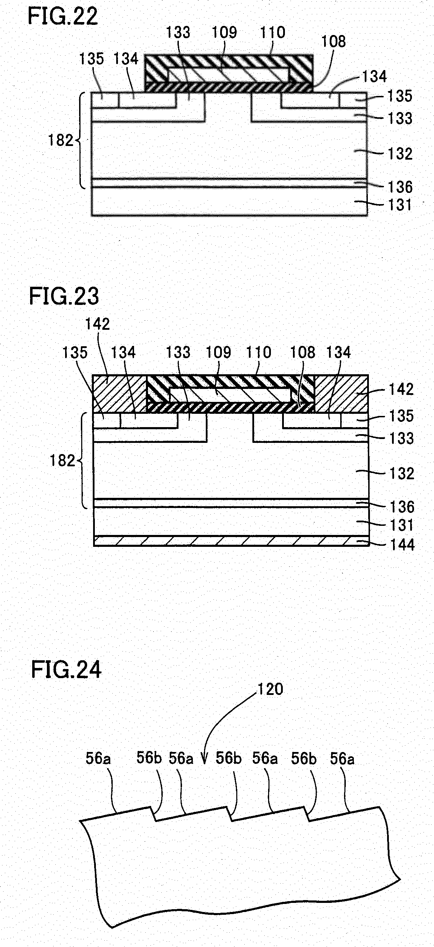

Referring to Fig. 22, interlayer insulating film 110 is formed to cover the upper surface of gate electrode 109 and the upper surface of gate insulating film 108 exposed. Next, openings are formed to expose contact regions 135 and portions of emitter regions 134.

As shown in Fig. 23, in each of the openings, emitter electrode 142 is formed to be an ohmic electrode making contact with each of emitter regions 134 and contact regions 135.

Further, collector electrode 144 serving as an ohmic electrode is formed on the backside surface of substrate 131 (the surface opposite to the side at which buffer layer 136 and drift layer 132 are formed).

Referring to Fig. 14 again, emitter wiring layer 143 is formed to make contact with the upper surface of emitter electrode 142 and extend on the upper surface of interlayer insulating film 110, and protecting electrode 115 is formed to cover collector electrode 144. In this way, IGBT 190 is obtained.

The following describes function and effect of the present embodiment.

According to the method for manufacturing IGBT 190 in the present embodiment, carbon film 150 (Fig. 17) is formed on the thermally etched surface of silicon carbide layer 180 (Fig. 16) during the thermal etching. Further, by the heat treatment in the thermal etching, carbon atoms are diffused from carbon film 150 to silicon carbide layer 180 (Fig. 16) and coupled to carbon vacancies in silicon carbide layer 180 (Fig. 16). Accordingly, silicon carbide layer 180 is changed into silicon carbide layer 181 (Fig. 17) having a lower carbon vacancy density. Accordingly, IGBT 190 (Fig. 14) having a higher quality silicon carbide layer is obtained.

Preferably, the process gas includes an etching gas containing chlorine atoms. This achieves increased reactivity of the process gas with silicon carbide.

Preferably, the process gas includes an oxidizing gas containing oxygen atoms. Accordingly, the reactivity of the process gas with carbon film 150 formed on the surface of silicon carbide layer 180 by the thermal etching on silicon carbide layer 180 can be increased.

Preferably, the concentration of the oxidizing gas in the process gas is decreased during the thermal etching. In this way, the etching rate for carbon film 150 is made small, thereby more sufficiently forming carbon film 150. Accordingly, carbon can be supplied more sufficiently from carbon film 150 into silicon carbide. More preferably, after the concentration of the oxidizing gas is decreased, the concentration of the oxidizing gas is increased. Accordingly, carbon film 150 formed to be sufficiently thick is etched at a high rate. On this occasion, carbon atoms are actively diffused into silicon carbide layer 180. Accordingly, the carbon vacancy density in silicon carbide layer 180 can be reduced further.

Further, according to the present embodiment, with the heat treatment performed after the thermal etching, carbon atoms are diffused from carbon film 150 into silicon carbide layer 181 (Fig. 17) and are coupled to carbon vacancies in silicon carbide layer 181. Accordingly, silicon carbide layer 181 is changed into silicon carbide layer 182 (Fig. 18) having a lower carbon vacancy density. Accordingly, IGBT 190 (Fig. 14) having a higher quality silicon carbide layer is obtained.

Further, the heat treatment after the thermal etching is performed at a temperature higher than the temperature at which the silicon carbide layer is heated in the thermal etching. Accordingly, the carbon atoms are diffused more actively, whereby the carbon vacancy density can be reduced more sufficiently. Simultaneously, with this heat treatment, the impurities can be activated. Moreover, because carbon film 150 serves as a cap film during the heat treatment for this activation, surface 120 (Fig. 17) can be suppressed from being rough due to the heat treatment.

Further, IGBT 190, which is the silicon carbide semiconductor device of the present embodiment, is a bipolar type semiconductor device. In the bipolar type semiconductor device, electrons and positive holes are both used as carriers. With the carbon vacancy density in the silicon carbide layer being reduced as described above, recombination of electrons with positive holes due to existence of carbon vacancies can be less frequent. Accordingly, performance of the bipolar type semiconductor device can be improved. Specifically, by improving the density of electrons and positive holes in IGBT 190, on-resistance can be reduced.

Further, according to the present embodiment, carbon film 150 is removed after the heat treatment. Accordingly, an unnecessary carbon film can be removed. Carbon film 150 can be readily removed using, for example, oxidation reaction.

In the present specification, the expression "surface 120 includes a {0-33-8} plane" is intended to indicate a concept including both a case where surface 120 substantially corresponds to the {0-33-8} plane and a case where there are a plurality of crystal planes constituting surface 120 and one of the crystal planes is the {0-33-8} plane. Now, the latter case is illustrated as follows. That is, surface 120 corresponds to a chemically stable plane constituted by, for example, alternately providing a plane 56a and a plane 56b as shown in Fig. 24, microscopically. Plane 56a has a plane orientation of {0-33-8} whereas plane 56b, which is connected to plane 56a, has a plane orientation different from that of plane 56a. Here, the term "microscopically" means "minutely to such an extent that at least the size about twice as large as an interatomic spacing is considered". Preferably, plane 56b has a plane orientation of {0-11-1}. More preferably, plane 56a having a plane orientation of {0-33-8} and plane 56b having a plane orientation of {0-11-1} are combined to constitute a {0-11-2} plane, macroscopically. Here, the term "macroscopically" means "a size sufficiently large is considered to such an extent that interatomic spacing can be ignored". More preferably, in surface 120 shown in Fig. 13, the length of plane 56a is twice as large as the interatomic spacing on plane 56a, and the length of plane 56b is twice as large as the interatomic spacing on plane 56b.

In the present specification, the expression "surface 120 includes a {0-11-4} plane" is intended to indicate a concept including both a case where surface 120 substantially corresponds to the {0-11-4} plane and a case where there are a plurality of crystal planes constituting surface 120 and one of the crystal planes is the {0-11-4} plane. Further, in the case where surface 120 includes the {0-33-8} plane, surface 120 more preferably includes the (0-33-8) plane. Further, in the case where surface 120 includes the {0-11-4} plane, surface 120 more preferably includes the (0-11-4) plane. Further, in the case where surface 120 includes the {0-11-1} plane, surface 120 more preferably includes the (0-11-1) plane.

In the present specification, the expression "surface 120 includes a {100} plane" is intended to indicate a concept including both a case where surface 120 substantially corresponds to the {100} plane and a case where there are a plurality of crystal planes constituting surface 120 and one of the crystal planes is the {100} plane.

It should be noted that the IGBT is not limited to n type and may be p type. It should be also noted that the IGBT has substrate 31 (Fig. 1) or substrate 131 (Fig. 14), but the substrate may be removed in the manufacturing process. Further, buffer layer 36 or 136 may be removed. Further, buffer layer 36 or 136 may not be used.

Further, the bipolar type semiconductor device is not limited to an IGBT, and may be, for example, a PIN (Positive Intrinsic Negative) diode or a GTO (Gate Turn-off Thyristor). Further, the silicon carbide semiconductor device is not limited to one including a bipolar type semiconductor device, and may be one including a unipolar type semiconductor device, for example. An exemplary unipolar type semiconductor device is an MIS (Metal Insulator Semiconductor) transistor or a Schottky barrier diode.

Further, in each of the above-described embodiments, the crystallographic plane orientations are exemplary and other plane orientations may be employed.

The embodiments disclosed herein are illustrative and non-restrictive in any respect. The scope of the present invention is defined by the terms of the claims, rather than the embodiments described above, and is intended to include any modifications within the scope of the claims.

### REFERENCE SIGNS LIST

6, 6v: trench; 8, 108: gate insulating film; 9, 109: gate electrode; 10, 110: interlayer insulating film; 15, 115: protecting electrode; 16: vertical trench; 17: mask layer; 20: side wall; 31, 131: substrate; 32, 132: drift layer; 33, 133: body region; 34, 134: emitter region; 35, 135: contact region; 36, 136: buffer layer; 42, 142: emitter electrode; 43, 143: emitter wiring layer; 44, 144: collector electrode; 50, 150: carbon film; 56a, 56b: plane; 80, 81, 82, 180, 181, 182: silicon carbide layer; 120: surface.

## Claims

1. A method for manufacturing a silicon carbide semiconductor device, comprising the steps of:
thermally etching a silicon carbide layer by supplying said silicon carbide layer with a process gas that is able to chemically react with silicon carbide at a temperature of not less than 700°C and not more than 1200°C, while heating said silicon carbide layer, a carbon film being formed on said silicon carbide layer by the step of thermally etching; and
after the step of thermally etching providing heat treatment to said silicon carbide layer to diffuse carbon from said carbon film into said silicon carbide layer.

2. The method for manufacturing the silicon carbide semiconductor device according to claim 1, wherein said silicon carbide semiconductor device includes a bipolar type semiconductor device.

3. The method for manufacturing the silicon carbide semiconductor device according to claim 1 or 2, wherein the step of providing heat treatment to said silicon carbide layer is performed at a temperature higher than a temperature at which said silicon carbide layer is heated in the step of thermally etching.

4. The method for manufacturing the silicon carbide semiconductor device according to any one of claims 1-3, wherein said process gas includes an etching gas containing chlorine atoms.

5. The method for manufacturing the silicon carbide semiconductor device according to any one of claims 1-4, wherein said process gas includes an oxidizing gas containing oxygen atoms.

6. The method for manufacturing the silicon carbide semiconductor device according to claim 5, wherein the step of thermally etching includes the step of decreasing concentration of said oxidizing gas in said process gas.

7. The method for manufacturing the silicon carbide semiconductor device according to any one of claims 1-6, further comprising the step of removing said carbon film remaining, after the step of providing heat treatment.

8. The method for manufacturing the silicon carbide semiconductor device according to any one of claims 1-7, wherein the step of thermally etching is performed to form a trench in said silicon carbide layer.

9. The method for manufacturing the silicon carbide semiconductor device according to claim 8, further comprising the step of forming a gate electrode in said trench.

## Patentansprüche

1. Verfahren zur Herstellung einer Siliziumkarbid-Halbleitervorrichtung, umfassend die Schritte:
thermisches Ätzen einer Siliziumkarbid-Schicht, indem der Siliziumkarbid-Schicht ein Prozessgas zugeführt wird, das in der Lage ist, bei einer Temperatur von nicht weniger als 700 °C und nicht mehr als 1200 °C mit Siliziumkarbid chemisch zu reagieren, während die Siliziumkarbid-Schicht erhitzt wird, wobei durch den thermischen Ätzschritt ein Kohlenstofffilm auf der Siliziumkarbid-Schicht gebildet wird; und
nach dem Schritt des thermischen Ätzens, Durchführen einer Wärmebehandlung auf der Siliziumkarbid-Schicht, sodass der Kohlenstoff von dem Kohlenstofffilm in die Siliziumkarbid-Schicht diffundiert.

2. Verfahren zur Herstellung der Siliziumkarbid-Halbleitervorrichtung nach Anspruch 1, wobei die Siliziumkarbid-Halbleitervorrichtung eine bipolare Halbleitervorrichtung ist.

3. Verfahren zur Herstellung der Siliziumkarbid-Halbleitervorrichtung nach Anspruch 1 oder 2, wobei der Wärmebehandlungsschritt auf der Siliziumkarbid-Schicht bei einer Temperatur durchgeführt wird, die höher als eine Temperatur ist, bei der die Siliziumkarbid-Schicht in dem thermischen Ätzschritt erhitzt wird.

4. Verfahren zur Herstellung der Siliziumkarbid-Halbleitervorrichtung nach einem der Ansprüche 1 bis 3, wobei das Prozessgas ein Ätzgas umfasst, das Chloratome enthält.

5. Verfahren zur Herstellung der Siliziumkarbid-Halbleitervorrichtung nach einem der Ansprüche 1 bis 4, wobei das Prozessgas ein Oxidationsgas umfasst, das Sauerstoffatome enthält.

6. Verfahren zur Herstellung der Siliziumkarbid-Halbleitervorrichtung nach Anspruch 5, wobei der thermische Ätzschritt den Schritt des Verringerns der Oxidationsgaskonzentration in dem Prozessgas umfasst.

7. Verfahren zur Herstellung der Siliziumkarbid-Halbleitervorrichtung nach einem der Ansprüche 1 bis 6, ferner umfassend den Schritt des Entfernens des Kohlenstofffilms, der nach dem Schritt des Bereitstellens der Wärmebehandlung übrig bleibt.

8. Verfahren zur Herstellung der Siliziumkarbid-Halbleitervorrichtung nach einem der Ansprüche 1 bis 7, wobei der Schritt des thermischen Ätzens durchgeführt wird, um einen Graben in der Siliziumkarbid-Schicht zu bilden.

9. Verfahren zum Herstellen der Siliziumkarbid-Halbleitervorrichtung nach Anspruch 8, ferner umfassend den Schritt des Ausbildens einer Gate-Elektrode in dem Graben.

## Revendications

1. Procédé de fabrication d'un dispositif semi-conducteur en carbure de silicium, comprenant les étapes de :
gravure thermique d'une couche de carbure de silicium en alimentant ladite couche de carbure de silicium avec un gaz de procédé qui est capable de réagir chimiquement avec le carbure de silicium à une température non inférieure à 700°C et non supérieure à 1 200°C, tout en chauffant ladite couche de carbure de silicium, un film de carbone étant formé sur ladite couche de carbure de silicium par l'étape de gravure thermique ; et
après l'étape de gravure thermique la fourniture d'un traitement thermique à ladite couche de carbure de silicium pour diffuser le carbone depuis ledit film de carbone dans ladite couche de carbure de silicium.

2. Procédé de fabrication du dispositif semi-conducteur en carbure de silicium selon la revendication 1, ledit dispositif semi-conducteur en carbure de silicium comprenant un dispositif semi-conducteur bipolaire.

3. Procédé de fabrication du dispositif semi-conducteur en carbure de silicium selon la revendication 1 ou 2, l'étape de fourniture du traitement thermique à ladite couche de carbure de silicium étant exécutée à une température supérieure à une température à laquelle ladite couche de carbure de silicium est chauffée dans l'étape de gravure thermique.

4. Procédé de fabrication du dispositif semi-conducteur en carbure de silicium selon l'une quelconque des revendications 1 à 3, ledit gaz de procédé comprenant un gaz de gravure contenant des atomes de chlore.

5. Procédé de fabrication du dispositif semi-conducteur en carbure de silicium selon l'une quelconque des revendications 1 à 4, ledit gaz de procédé comprenant un gaz oxydant contenant des atomes d'oxygène.

6. Procédé de fabrication du dispositif semi-conducteur en carbure de silicium selon la revendication 5, l'étape de gravure thermique comprenant l'étape de réduction de la concentration dudit gaz oxydant dans ledit gaz de procédé.

7. Procédé de fabrication du dispositif semi-conducteur en carbure de silicium selon l'une quelconque des revendications 1 à 6, comprenant en outre l'étape d'élimination dudit film de carbone restant, après l'étape de fourniture de traitement thermique.

8. Procédé de fabrication du dispositif semi-conducteur en carbure de silicium selon l'une quelconque des revendications 1 à 7, l'étape de gravure thermique étant exécutée pour former une tranchée dans ladite couche de carbure de silicium.

9. Procédé de fabrication du dispositif semi-conducteur en carbure de silicium selon la revendication 8, comprenant en outre l'étape de formation d'une électrode de grille dans ladite tranchée.
